# EUROPEAN PATENT SPECIFICATION

(11) **EP 3 944 577 B1**
(45) Date of publication and mention of the grant of the patent: **04.12.2024**
(21) Application number: 20907582.9
(22) Date of filing: 17.12.2020
(51) Int. Cl.: H04L 25/49, H03F 1/32

(54) **PRE-DISTORTION PROCESSING DEVICE, SIGNAL TRANSMISSION SYSTEM, AND PRE-DISTORTION PROCESSING METHOD**
VORVERZERRUNGVERARBEITUNGSVORRICHTUNG, SIGNALÜBERTRAGUNGSSYSTEM UND VORVERZERRUNGVERARBEITUNGSVERFAHREN
DISPOSITIF DE TRAITEMENT DE PRÉ-DISTORSION, SYSTÈME D'ÉMISSION DE SIGNAL ET PROCÉDÉ DE TRAITEMENT DE PRÉ-DISTORSION

(30) Priority: 25.12.2019 CN 201911353866
(43) Date of publication of application: 26.01.2022
(73) Proprietor: Sunwave Communications Co., Ltd., Hangzhou, Zhejiang 310053 (CN)
(72) Inventor: YU, Liguang, Hangzhou, Zhejiang 310053 (CN); HE, Wang, Hangzhou, Zhejiang 310053 (CN); HU, Xiaofei, Hangzhou, Zhejiang 310053 (CN)
(74) Representative: Meyer-Dulheuer MD Legal Patentanwälte PartG mbB
(86) International application number: PCT/CN2020/137050
(87) International publication number: WO 2021/129494

(56) References cited:
- CN-A- 103 650 444
- CN-A- 103 858 337
- CN-A- 105 978 493
- CN-A- 110 572 341
- CN-A- 110 572 341
- CN-A- 110 912 519
- CN-A- 111 147 412
- US-A1- 2008 129 379
- US-B1- 8 929 483

## Description

### TECHNICAL FIELD

The present disclosure generally relates to the technical field of signal transmission, and in particular, to a pre-distortion processing device, a signal transmission system, and a pre-distortion processing method.

### BACKGROUND

Pre-distortion, as a solution to improve linearity of radio frequency power amplifier, is widely applied in modern communication field. Pre-distortion technology can have stable correction effects for signals of 3G (3rd-Generation, third generation mobile communication technology), TD-SCDMA (Time Division-Synchronous Code Division Multiple Access), WCDMA (Wideband Code Division Multiple Access) and LTE (Long Term Evolution) in 4G (4th-Generation, fourth generation mobile communication technology) mobile communication system and other signals. However, due to a limited correction ability of a pre-distortion algorithm for narrowband signals and frequency hopping signals, a correction effect is inadequate and the signals are prone to jitter when narrowband signals such as GSM (Global System for Mobile Communications) are corrected. The pre-distortion technology cannot be properly used in this system.

CN110572341 discloses a DPD (digital pre-distortion) processing method and a device. A broadband orthogonal IQ signal is obtained, a pre-distortion coefficient of DPD processing is determined according to a forward path signal and a feedback path signal corresponding to the broadband orthogonal IQ signal, a normal path signal is obtained, the DPD processing is carried out on the normal path signal according to the pre-distortion coefficient, and the normal path signal after the DPD processing is subjected to power amplification processing.

US8929483B1 discloses a multi-channel digital linearization. Digital baseband channel signals are received and up-sampled to a common sampling rate. The digital baseband channel signals are filtered using low pass filters. Complex frequency shifting is performed of the filtered digital baseband channel signals based on the associated different channel frequencies to obtain digital channel signals, which are combined to generate a digital wideband multi-channel signal that is a digital representation of an analog wideband multi-channel signal that is based on combining analog channel signals that correspond to the analog baseband channel signals. A non-linear pre-distortion of the digital wideband multi-channel signal is performed, the non-linear pre-distortion adding at least one of a gain and a phase shift to the digital wideband multi-channel signal such that the digital channel signals included within the digital wideband multi-channel signal are compensated for a non-linear distortion effected on the analog wideband multi-channel signal by a high-power amplifier.

An effective solution for the poor correction effect of pre-distortion processing on narrowband signals or frequency hopping signals has yet to be proposed.

### SUMMARY

According to various embodiments of the present disclosure, a pre-distortion processing device is provided. The pre-distortion processing device includes a pre-distortion unit, a transmission unit and a coupling unit which are sequentially connected. A feedback path of the coupling unit is connected to the pre-distortion unit, and the pre-distortion processing device further includes a generation unit and a combiner unit. The generation unit is configured to generate a wideband signal having a bandwidth greater than that of a system input signal, and the wideband signal is a non-hopping signal; and the combiner unit includes a first input terminal, a second input terminal and an output terminal. The first input terminal of the combiner unit is connected to an output terminal of the generation unit, the second input terminal of the combiner unit is configured to receive the system input signal, the output terminal of the combiner unit is connected to an input terminal of the pre-distortion unit, the combiner unit is configured to combine the wideband signal and the system input signal into a combined signal and output the combined signal to the pre-distortion unit.

In an embodiment of the present disclosure, the device further includes a filtering unit, an input terminal of the filtering unit is connected to an output terminal of the coupling unit, and an output terminal of the filtering unit is connected to an antenna.

In an embodiment of the present disclosure, a frequency of the wideband signal processed by the transmission unit is outside a passband frequency range of the filtering unit
In an embodiment of the present disclosure, an interval between the frequency of the wideband signal processed by the transmission unit and the passband frequency of the filtering unit is within a preset range.

In an embodiment of the present disclosure, a number of the wideband signal generated by the generation unit is one or more; when a plurality of wideband signals are generated by the generation unit, a frequency of at least one of the plurality of wideband signals is less than that of the system input signal, and a frequency of at least one of the plurality of wideband signals is greater than that of the system input signal.

In an embodiment of the present disclosure, the wideband signal includes at least one of a WCDMA signal and a LTE signal.

In an embodiment of the present disclosure, the filtering unit is configured to filter the wideband signal processed by the transmission unit and a spurious signal in an output signal of the transmission unit, and the spurious signal includes intermodulation signals generated by the wideband signal.

According to various embodiments of the present disclosure, a signal transmission system is further provided. The signal transmission system includes any one of the above pre-distortion processing device.

According to various embodiments of the present disclosure, a pre-distortion processing method is further provided. The pre-distortion processing method includes: receiving a combined signal by a pre-distortion unit, the combined signal including a wideband signal and a system input signal, a bandwidth of the wideband signal being greater than that of the system input signal, and the wideband signal being a non-hopping signal; receiving a feedback signal by the pre-distortion unit, the feedback signal being a signal coupled from an output signal, and the output signal being obtained by power amplification of the combined signal; and performing pre-distortion processing on the combined signal by the pre-distortion unit according to the feedback signal and obtaining the combined signal after pre-distortion processing.

In an embodiment of the present disclosure, the combined signal after pre-distortion processing is power-amplified into the output signal, and a processed wideband signal and a spurious signal are filtered out of the output signal, and the spurious signal includes intermodulation signals generated by the wideband signal.

The above pre-distortion processing device, the signal transmission system, and the pre-distortion processing method have the following advantages: through the generation unit and the combiner unit in the pre-distortion processing device, the wideband signal is combined in the system input signal, resulting in that the signal pre-distorted in a pre-distortion unit is more stable than the system input signal. In this case, even if a bandwidth of the system input signal is small, or an amplitude and a frequency of the system input signal change significantly, due to the wideband signal in the combined signal, a bandwidth and an amplitude of an input signal of the pre-distortion unit will be stable within a certain range. It means that the pre-distortion processing is performed on a stable wideband signal for the pre-distortion unit, solving an issue of poor correction effect of a pre-distortion processing on narrowband signals or frequency hopping signals caused by inconsistent amplitude-frequency characteristics of the signal transmission system or defects of pre-distortion algorithm, and improving pre-distortion correction effect on the narrowband signals and the frequency hopping signals.

### BRIEF DESCRIPTION OF THE DRAWINGS

To describe and illustrate embodiments and/or examples of the present disclosure made public here better, reference may be made to one or more of the figures. The additional details or examples used to describe the figures should not be construed as limiting the scope of any of the present disclosure, the embodiments and/or examples currently described, and the best model of the present disclosure as currently understood.
FIG. 1 is a schematic diagram of a pre-distortion processing device in an embodiment of the present disclosure.
FIG. 2 is a first flowchart diagram of a pre-distortion processing device in a preferred embodiment of the present disclosure.
FIG. 3 is a flowchart diagram of a pre-distortion processing method in an embodiment of the present disclosure.
FIG. 4 is a second flowchart diagram of a pre-distortion processing device in a preferred embodiment of the present disclosure.
FIG. 5 is a flowchart diagram of a pre-distortion processing method in a preferred embodiment of the present disclosure.
FIG. 6 is an amplitude-frequency schematic diagram of a system input signal in a preferred embodiment of the present disclosure.
FIG. 7 is an amplitude-frequency schematic diagram of a wideband signal in a preferred embodiment of the present disclosure.
FIG. 8 is an amplitude-frequency schematic diagram of a combined signal of a system input signal and a wideband signal in a preferred embodiment of the present disclosure.
FIG. 9 is an amplitude-frequency schematic diagram of an output signal of a coupling unit in a preferred embodiment of the present disclosure.
FIG. 10 is an amplitude-frequency schematic diagram of a signal with nonlinear correction by a pre-distortion unit in a preferred embodiment of the present disclosure.
FIG. 11 is an amplitude-frequency schematic diagram of an output signal of a filtering unit in a preferred embodiment of the present disclosure.

### DETAILED DESCRIPTION OF THE EMBODIMENTS

The present disclosure will be further described in detail below with reference to the drawings and specific embodiments, in order to better understand the objective, the technical solution and the advantage of the present disclosure. It should be understood that the specific embodiments described herein are merely illustrative and are not intended to limit the scope of the present disclosure. Based on the embodiments of the present disclosure, all other embodiments obtained by a person of ordinary skill in the art without creative efforts all belong to the scope of protection of the present disclosure.

It is apparent that the drawings in the following description are only some examples or embodiments of the present disclosure, and the present disclosure can be applied to other similar scenarios based on these drawings without creative effort to the person of ordinary skill in the art. It is also understood that, although the efforts made in such development process may be complex and lengthy, some changes like design, manufacturing or production based on the technical content disclosed in the present disclosure are only conventional technical means for the person of ordinary skill in the art related to the content disclosed in the present disclosure, and should not be construed as inadequate for the content disclosed in the present disclosure.

References to "embodiment" in the present disclosure mean that particular features, structures, or characteristics described in connection with an embodiment may be included in at least one embodiment of the present disclosure. The occurrence of the phrase at various points in the specification does not necessarily mean the same embodiment, nor is it a separate or alternative embodiment that is mutually exclusive with other embodiments. It is understood, both explicitly and implicitly, by the person of ordinary skill in the art that the embodiments described in the present disclosure may be combined with other embodiments.

Unless otherwise defined, the technical terms or scientific terms involved in the description and claims of the present disclosure shall have the ordinary meaning as understood by the person of ordinary skill in the art to which the present disclosure belongs. The terms "one", "a", "an", "the" and similar terms used in the description and claims do not indicate a quantitative limitation, and can mean/connote/include singular or plural. The terms "include", "comprise" and any similar words mean that an element or an object that is preceded by "include" or "comprise" covers an element or an object listed and its equivalent after "include" or "comprise", not excluding other elements or objects. The terms "connection", "connected" and similar terms are not limited to physical or mechanical connections, but may include electrical connections directly or indirectly. The term "plurality" as used in description and claims of the present disclosure refers to two or more. The words "at least one of" describes the relationship of the associated objects and indicates that three relationships can exist, for example, "at least one of A and B" can indicate the presence of A alone, A and B together, and B alone. The character "/" usually indicates an "or" relationship between associated objects.

The technologies described in the present disclosure can be used in a variety of wireless communication systems, such as 2G, 3G, 4G, 5G communication systems and next-generation communication systems, as well as Global System for Mobile Communications (GSM), Code Division Multiple Access (CDMA) systems, Time Division Multiple Access (TDMA) systems, Wide Band Code Division Multiple Access Wireless (WCDMA) systems, Frequency Division Multiple Addressing (FDMA) systems, Orthogonal Frequency Division Multiple Access (OFDMA) systems, Single Carrier FDMA (SC-FDMA) systems, General Packet Radio Service (GPRS) systems, Long Term Evolution (LTE) systems, 5G New Radio (NR) systems and other such communication systems.

A pre-distortion processing device and a pre-distortion processing method provided in the embodiment can be applied to a signal transmission system, including but not limited to a digital repeater or a radio frequency remote unit.

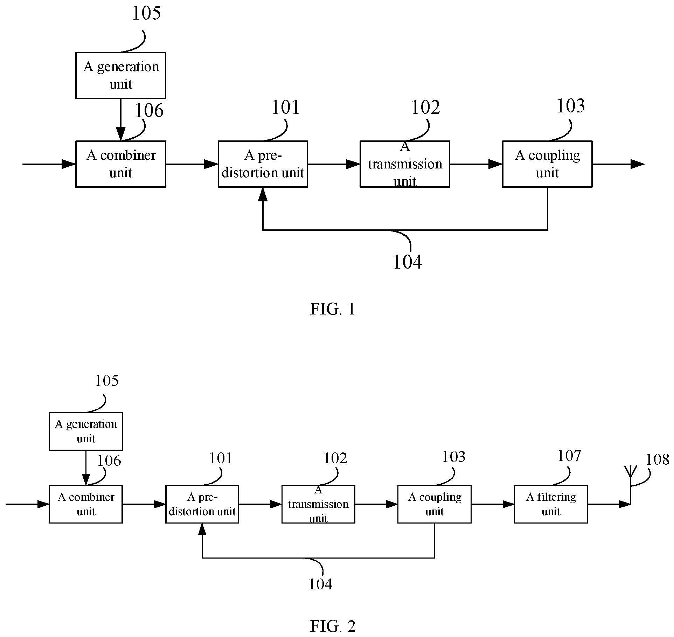

A pre-distortion processing device is provided in the embodiment. FIG. 1 is a schematic diagram of a pre-distortion processing device in an embodiment of the present disclosure. The pre-distortion processing device includes a pre-distortion unit 101, a transmission unit 102 and a coupling unit 103 which are sequentially connected, and a feedback path 104 of the coupling unit 103 is connected to the pre-distortion unit 101.

The pre-distortion unit 101 is a nonlinear correction part of the pre-distortion processing device. The pre-distortion unit 101 performs nonlinear correction on an input signal according to a system input signal and a feedback signal by a preset pre-distortion algorithm.

The transmission unit 102 acts as a power amplifier in the pre-distortion processing device, and may be used for signal modulation, spectrum shifting and filtering in some signal transmission systems.

In a pre-distortion processing device based on digital pre-distortion technology, the transmission unit 102 may include but is not limited to at least one of the following sub-units: a digital to analog conversion sub-unit, a mixing sub-unit, and a power amplifier sub-unit, etc., and the power amplifier sub-unit usually includes elements with memory effect and nonlinear characteristics. The transmission unit 102 is configured to convert a baseband signal output by the pre-distortion unit 101 into a power-amplified radio-frequency signal.

In a pre-distortion processing device based on analog pre-distortion technology, the transmission unit 102 may include but is not limited to the power amplifier sub-unit, and the power amplifier sub-unit usually includes elements with memory effect and nonlinear characteristics. The transmission unit 102 is configured to power-amplify the baseband signal output by the pre-distortion unit 101.

The coupling unit 103 is configured to couple a part of an output signal of the transmission unit 102 as a feedback signal and provide the feedback signal to the pre-distortion unit 101 for pre-distortion processing of the baseband signal. The coupling unit 103 outputs most of the output signal of the transmission unit 102 to an antenna.

In the above pre-distortion processing device, distortion interference will occur to an amplified signal due to the existence of devices with memory effect and nonlinear characteristics in the transmission unit 102. After sampling the output signal of the transmission unit 102 through the coupling unit 103, the pre-distortion processing device transmits a sampled feedback signal to the pre-distortion unit 101. The pre-distortion unit 101 adaptively learns nonlinear characteristics of the transmission unit 102 to obtain pre-distortion parameters. Finally, the pre-distortion unit 101 cancels a nonlinear distortion produced by the transmission unit 102 according to the pre-distortion parameters to realize the pre-distortion processing. The pre-distortion algorithm in the present disclosure can be any of existing pre-distortion algorithms.

In a traditional pre-distortion processing device with the pre-distortion unit, the transmission unit and the coupling unit, the pre-distortion unit calculates the nonlinearity of the signal transmission system by comparing the input signal and the feedback signal of the signal transmission system. However, when the input signal of the signal transmission system is a narrow-band signal, a frequency hopping signal or an amplitude hopping signal, due to inconsistent amplitude-frequency characteristics of the signal transmission system itself or defects of the pre-distortion algorithm, correction of the pre-distortion unit will be affected, resulting in that an intermodulation is distorted and stable, and an intermodulation power will jump.

To solve the above problem, the pre-distortion processing device provided in an embodiment further includes a generating unit 105 and a combiner unit 106.

The generation unit 105 is connected to the combiner unit 106 and configured to generate a wideband signal. The wideband signal has a bandwidth greater than that of the system input signal, and the wideband signal is a non-hopping signal. In some embodiments, the wideband signal includes but is not limited to at least one of a WCDMA signal and a LTE signal.

The combiner unit 106 includes at least a first input terminal, a second input terminal and an output terminal. The first input terminal of the combiner unit 106 is connected to an output terminal of the generation unit 105, the second input terminal of the combiner unit 106 is configured to receive the system input signal, and the output terminal of the combiner unit 106 is connected to an input terminal of the pre-distortion unit 101.

In the embodiment of the present disclosure, through the generation unit 105 and the combiner unit 106 in the pre-distortion processing device, the wideband signal is combined in the system input signal, resulting in that the signal pre-distorted in a pre-distortion unit 101 is more stable than the system input signal. In this case, even if a bandwidth of the system input signal is small, or an amplitude and a frequency of the system input signal change significantly, due to the wideband signal in the combined signal, a bandwidth and an amplitude of an input signal of the pre-distortion unit 101 will be stable within a certain range. It means that the pre-distortion processing is performed on a stable wideband signal for the pre-distortion unit 101, solving an issue of poor correction effect of a pre-distortion processing on narrowband signals or frequency hopping signals caused by inconsistent amplitude-frequency characteristics of the signal transmission system or defects of pre-distortion algorithm, and improving pre-distortion correction effect on the narrowband signals and the frequency hopping signals.

When one or more wideband signals are introduced into the signal transmission system, the wideband signal itself, an intermodulation signal generated by multiple wideband signals acting on a nonlinear circuit, and an intermodulation signal generated by the wideband signal and the system input signal of the signal transmission system acting on a nonlinear circuit will affect a spurious level of the signal transmission system. In order to remove or reduce a spurious signal, a filtering unit can be added to an output part of the signal transmission system in some embodiments.

As shown in FIG. 2, in some preferred embodiments, the pre-distortion processing device further includes a filtering unit 107, an input terminal of the filtering unit 107 connected to an output terminal of the coupling unit 103, and an output terminal of the filtering unit 107 connected to an antenna 108. The filtering unit 107 is configured to filter or reduce the wideband signal in the output part of the signal transmission system and the spurious signal including multiple intermodulation signals, so as to improve the spurious level of the signal transmission system.

In some embodiments, the filtering unit 107 can be a bandpass filter. The bandpass filter has a small insertion loss of the passband of the signal transmission system. In order to filter out the wideband signal processed by the transmission unit smoothly, in the present disclosure, a frequency of the wideband signal processed by the transmission unit is set to be outside a passband frequency range of the filtering unit 107, resulting in that the filtering unit 107 suppresses the wideband signal processed by the transmission unit and intermodulation signals.

In some embodiments, a number of the wideband signal generated by the generating unit 105 can be one or more. In order that a frequency of an output signal obtained after the wideband signal is modulated, spectrum shifted and transformed can be outside a band frequency range of the signal transmission system and successfully suppressed by the filtering unit 107, the frequency of the wideband signal is set to be greater than or less than that of the system input signal.

In the case of multiple wideband signals generated by generating unit 105, a frequency of at least one of the wideband signals is less than that of the system input signal, and a frequency of at least one of the wideband signals (i.e., other wideband signal other than those whose frequency are less than frequency of the system input signal) is greater than that of the system input signal, resulting in that the frequency of the output signal obtained after the wideband signal is modulated, spectrum shifted and transformed can be outside the passband frequency range of the filtering unit 107. In the embodiment, by setting the frequency of the wideband signal, the filtering unit 107 at the output terminal of the coupling unit 103 filters out the wideband signal processed by the transmission unit and the intermodulation signals, resulting in that the signal transmission system reduces spurious interference on the premise of linear enhancement.

Experimental results show that the farther the frequency of the wideband signal processed by the transmission unit is away from the passband frequency of the filtering unit 107, the worse the pre-distortion correction effect of the signal transmission system is, but the better suppression effect of the filtering unit 107 is on the wideband signal processed by the transmission unit and the intermodulation signals. Therefore the frequency of the wideband signal should be determined according to the power of the wideband signal itself and a suppression performance of the filtering unit 107 on the wideband signal processed by the transmission unit and the intermodulation signals, so that the frequency of the wideband signal processed by the transmission unit is close enough to the passband frequency of the signal transmission system to ensure pre-distortion correction performance, while the filtering unit 107 should have enough suppression to ensure that the wideband signal processed by the transmission unit and the intermodulation signals are small enough. In general, the intermodulation signals can be ignored if powers of the intermodulation signals are relatively small and frequencies of the intermodulation signals are away from the passband frequency of the signal transmission system. For example, a power of a wideband signal output by the coupling unit 103 is 20 dBm, while a spurious power of outside passband required by the signal transmission system is -36 dBm, so the filtering unit 107 is required to suppress 56 dB of the wideband signal processed by the transmission unit. At the same time, the filtering unit 107 has a suppression of more than 56 dB at 10 MHz to 200 MHz outside passband, so the frequency of the wideband signal processed by the transmission unit can be set at 10 MHz outside passband to ensure that the bandpass filter has enough suppression and the wideband signal processed by the transmission unit is as close as possible to the passband of the signal transmission system.

In an embodiment of the present disclosure, a signal transmission system is provided. The signal transmission system includes the pre-distortion processing device in any one of the above embodiments. The signal transmission system can be an optical fiber repeater, a radio frequency remote unit, or any other signal transmission system that requires pre-distortion processing.

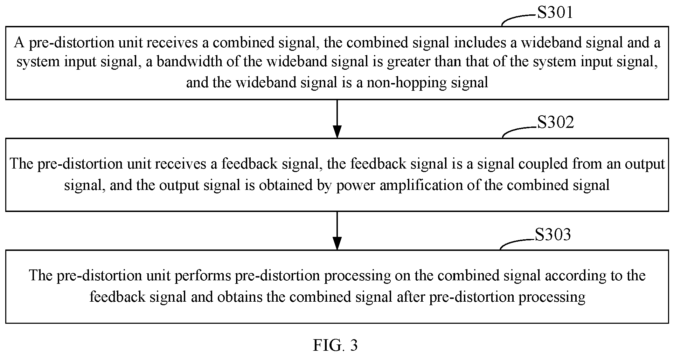

In an embodiment of the present disclosure, a pre-distortion processing method is provided. FIG. 3 is a flowchart diagram of a pre-distortion processing method in an embodiment of the present disclosure. The flowchart includes the following steps: at step 301, a pre-distortion unit receives a combined signal, the combined signal includes a wideband signal and a system input signal, a bandwidth of the wideband signal is greater than that of the system input signal, and the wideband signal is a non-hopping signal.

In the above step, the system input signal refers to a useful signal that the signal transmission system actually needs to send, the wideband signal is a signal with a larger bandwidth than that of the system input signal, and the wideband signal is a non-hopping signal.

At step 302, the pre-distortion unit receives a feedback signal, the feedback signal is a signal coupled from an output signal, and the output signal is obtained by power amplification of the combined signal.

In the above step, the feedback signal is a signal coupled from the output signal. Because the distortion interference occurs after the output signal has been processed by the devices with memory effect and nonlinear effect such as power amplifier, the feedback signal reflects characteristic changes of the devices with memory effect and nonlinear effect by coupling a part of the output signal as the feedback signal.

At step 303, the pre-distortion unit performs pre-distortion processing on the combined signal according to the feedback signal and obtains the combined signal after pre-distortion processing.

In the above step, the pre-distortion unit learns the characteristic changes of the elements with memory effect and nonlinear effect in the signal transmission system, determines the pre-distortion parameters and realizes the pre-distortion processing.

Through the above steps, the wideband signal and the system input signal are combined, and the input signal of the pre-distortion unit is transformed into a more stable signal, resulting in that some signals that are not suitable for pre-distortion processing can also achieve stable correction effect through pre-distortion processing, solving the issue of poor correction effect of a pre-distortion processing on narrowband signals or frequency hopping signals, improving pre-distortion correction effect on the narrowband signals and the frequency hopping signals, and improving a linear index of the signal transmission system.

After the step 303, the combined signal after pre-distortion processing in the embodiment of the present disclosure is usually power amplified into the output signal, which is then transmitted by the antenna. However, compared with the output signal generated according to the system input signal, the output signal transmitted by the antenna further includes the output signal generated according to the wideband signal, and the spurious signal such as the intermodulation signals generated due to the wideband signal. Therefore, in the embodiment, the signal to be transmitted through the antenna can also be filtered, so as to filter the wideband signal processed by the transmission unit and the spurious signal. The filtering unit configured to filter the wideband signal processed by the transmission unit and the spurious signal can be set between the coupling unit and a transmitting antenna of the transmission unit at present level, or between a low noise amplifier and a receiving antenna of the transmission unit at next level. Preferably, the filtering unit is set between the transmission unit and the transmitting antenna of the transmission unit.

In order to demonstrate principles and beneficial effects of the pre-distortion processing device, the signal transmission system and the pre-distortion processing method provided in the present disclosure, the present disclosure will be described and illustrated by preferred embodiments below.

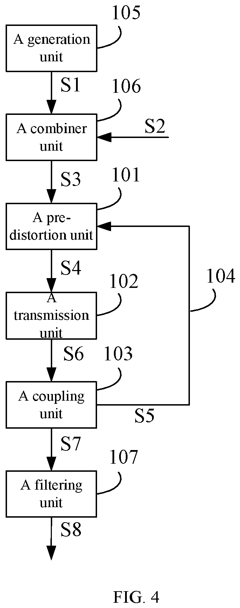

FIG. 4 is a second flowchart diagram of a pre-distortion processing device in a preferred embodiment of the present disclosure. The pre-distortion processing device includes a generating unit 105, a combiner unit 106, a pre-distortion unit 101, a transmission unit 102, a coupling unit 103, a feedback path 104 and a filtering unit 107.

The generation unit 105 generates one or more wideband signals S1 and output the wideband signal S 1 to the combiner unit 106.

Alternatively, the frequency of the wideband signal processed by the transmission unit is outside system frequency band.

Alternatively, the wideband signal includes but is not limited to a WCDMA signal, a LTE signal and other modulation signals suitable for pre-distortion algorithm processing.

The combiner unit 106 has two input terminals, a first input terminal receives an output signal S 1 of the generation unit 105 (equivalent to the wideband signal at step 301), and a second input terminal receives the system input signal S2 (equivalent to the system input signal at step 301). Two signals are combined at the combiner unit 106 to acquire the combined signal S3 (equivalent to the combined signal at step 301). At the same time, the combined signal is output to the pre-distortion unit 101.

The pre-distortion unit 101 includes a first input terminal, a second input terminal and an output terminal. The first input terminal receives the combined signal S3 output by the combiner unit, the second input terminal receives a feedback signal S5 (equivalent to the feedback signal at step 302) transmitted through the feedback path 104, and the output terminal outputs a signal S4 processed by the pre-distortion. The pre-distortion unit 101 is a nonlinear correction part of the system. The pre-distortion unit 101 performs a specific algorithm to correct a nonlinear of the signal transmission system according to the input combined signal S3 and the feedback signal S5 of the system, improving the linear index of the signal transmission system.

The transmission unit 102 is configured to process the system input signal, including a digital-analog conversion, a mixing and an amplification, etc., and is also the nonlinear part generated by the system. The transmission unit receives the output signal S4 of the pre-distortion unit 101. After the digital-analog conversion, the mixing and the amplification, a signal S6 (equivalent to the output signal obtained by power amplification of the combined signal at step 302) is output to the coupling unit 103.

The coupling unit 103 includes an input terminal, a first output terminal and a second output terminal. The input terminal receives the signal S6 of the transmission unit 102, the first output end is connected to the input terminal of the filtering unit 107, and the second output terminal is connected to the second input terminal of the pre-distortion unit 101. A function of the coupling unit 103 is to couple a part of the signal S6 output by the transmission unit 102 as S5 (equivalent to the feedback signal in step S302) to the pre-distortion unit 101 and output most of the signal S6 as a signal S7 to the antenna.

The input terminal of the filtering unit 107 is connected to the first output terminal of the coupling unit 103, and the output terminal of the filtering unit 107 is an output terminal of the pre-distortion processing device which is configured to be connected to the antenna. A function of the filtering unit 107 is to filter the wideband signal S1 in the signal S7 output from the coupling unit 103, the wideband signal processed by the transmission unit 102, the intermodulation signals between the wideband signal and the system input signal, and other spurious signals from the system to obtain a system output signal S8.

Alternatively, the filtering unit 107 can be a bandpass filter. The bandpass filter has a small insertion loss of the passband of the system, and the bandpass filter has a great suppression effect on the frequency of the wideband signal processed by the transmission unit 102 and the frequency of the intermodulation signals.

Alternatively, the farther the frequency of the wideband signal processed by the transmission unit 102 is away from the passband frequency of the system, the worse the pre-distortion correction effect of the system is, but at the same time, the greater suppression effect of the bandpass filter is on the wideband signal processed by the transmission unit 102. Therefore, in the present disclosure, the frequency of the wideband signal processed by the transmission unit 102 is reasonably allocated based on indicators of the bandpass filter and a correction ability of system pre-distortion technology.

In the present disclosure, the pre-distortion processing device introduces the wideband signal suitable for pre-distortion processing into the system in the combiner unit 106, filters out the introduced wideband signal processed by the transmission unit 102 and the spurious signal such as the intermodulation signals, resulting in that the pre-distortion technology can also be used in systems that are not suitable for the pre-distortion technology such as narrowband communication system. In addition, the linear index of the system is improved without generating a too large spurious signal.

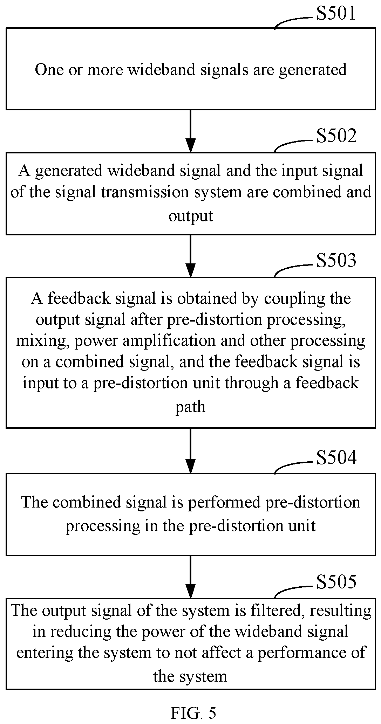

A pre-distortion processing method is further provided in a preferred embodiment of the present disclosure. The pre-distortion processing method can be applied to a pre-distortion system using digital pre-distortion technology. FIG. 5 is a flowchart diagram of a pre-distortion processing method in a preferred embodiment of the present disclosure. The flowchart includes the following steps: at step 501, one or more wideband signals are generated.

In the present disclosure, the wideband signal is relative to a narrowband signal, a time domain hopping signal or a frequency domain hopping signal input by the system, and has characteristics of wider signal bandwidth and relatively stable change in time domain or frequency domain. The existing pre-distortion algorithm has better correction effect for this kind of signal.

Alternatively, the wideband signal can be a WCDMA signal, a LTE signal, etc.

Alternatively, the frequency of the wideband signal processed by the transmission unit is outside the passband frequency range of the system in the frequency domain.

Alternatively, a spectrum of the wideband signal processed by the transmission unit is on both sides of the passband frequency range of the system.

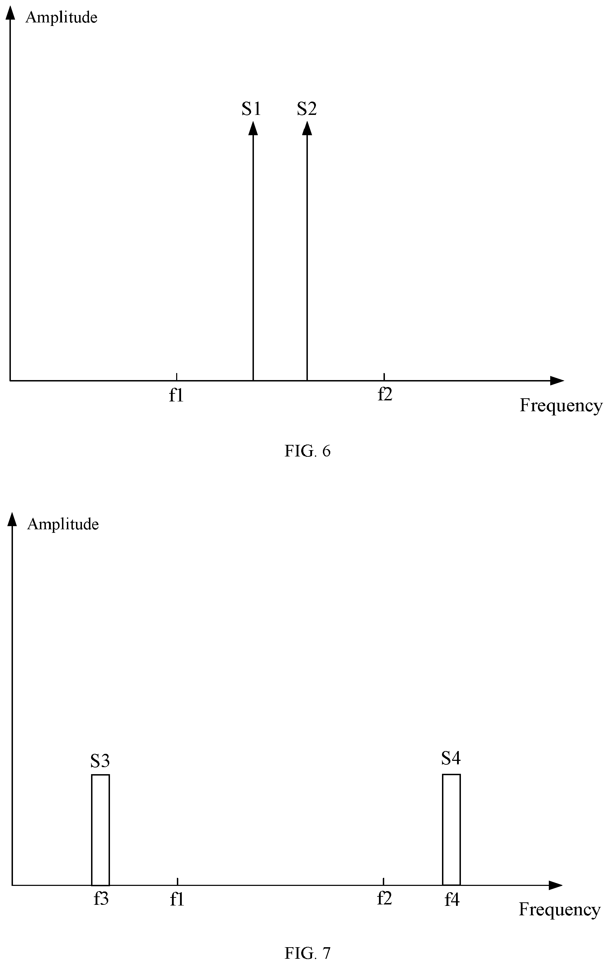

FIG. 6 is an amplitude-frequency schematic diagram of a system input signal in an embodiment of the present disclosure. A beginning frequency of the input signal of the signal transmission system is denoted as f1, an ending frequency of the input signal of the signal transmission system is denoted as f2, and dual carrier signals actual input are denoted as S1 and S2 respectively. The signals S1 and S2 have small bandwidth and are frequency hopping signals, and the effect of pre-distortion is poor. On this basis, two wideband signals are generated in the signal transmission system in the present disclosure. FIG. 7 is an amplitude-frequency schematic diagram of a wideband signal in an embodiment of the present disclosure. Two wideband signals are denoted as S3 and S4 respectively. A signal frequency of S3 is denoted as f3, a signal frequency of S4 is denoted as f4, f3 is less than f1, and f4 is greater than f2. A pre-distortion result reflects actual nonlinear characteristics in the passband of the system due to this kind configuration of the wideband signal, and an actual output signal is more linear.

At step 502, a generated wideband signal and the input signal of the signal transmission system are combined and output.

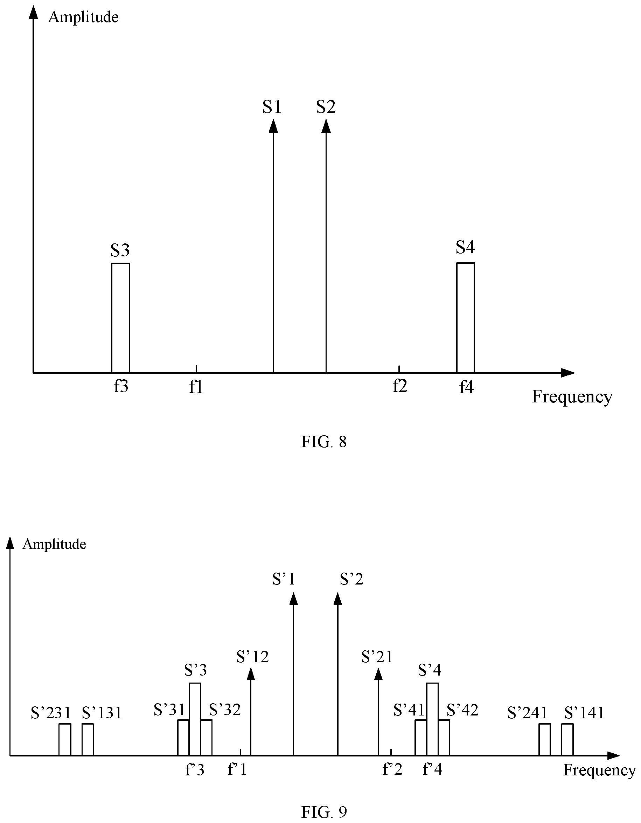

FIG. 8 is an amplitude-frequency schematic diagram of a combined signal of a system input signal and a wideband signal in an embodiment of the present disclosure. An actual signal of the signal transmission system has included the wideband signals S3 and S4, which have a better correction effect in the pre-distortion system.

At step 503, a feedback signal is obtained by coupling the output signal after pre-distortion processing, mixing, power amplification and other processing on a combined signal, and the feedback signal is input to a pre-distortion unit through a feedback path.

The combined signal is processed by a signal transmission part of the signal transmission system, especially after a power amplification processing, nonlinear distortion will occur, and nonlinear components produced include third-order intermodulation signals. As shown in FIG. 9, the third-order intermodulation signals of the system input signal S'1 (refers to a signal obtained from the signal S1 after processed by the transmission unit 102) and the system input signal S'2 (refers to a signal obtained from the signal S1 after processed by the transmission unit 102) are denoted as S'12 and S'21. The intermodulation signals of the wideband signals S'3 (refers to a signal obtained from the signal S3 after processed by the transmission unit 102) and the wideband signals S'4 (refers to a signal obtained from the signal S4 after processed by the transmission unit 102) are denoted as S'31, S'32, S'41 and S'42. The intermodulation signals between the system input signals and the wideband signals are denoted as S'231, S'131, S'241 and S'141. Therefore, in the embodiment, after signal coupling processing, the output signal output by the transmission unit 102 (including the output signal corresponding to the system input signal, the output signal corresponding to the wideband signal, and the intermodulation signals) is input to the pre-distortion unit 101, for the pre-distortion unit 101 to perform pre-distortion processing on the current combined signal.

At step 504, the combined signal is performed pre-distortion processing in the pre-distortion unit.

As the combined signal includes the wideband signal, compared with an original input signal, the combined signal is more suitable for the pre-distortion processing, so the pre-distortion correction effect is improved.

The pre-distortion unit 101 calculates the nonlinearity of the signal transmission system by comparing the input signal and the feedback signal of the signal transmission system. When the input signal of the signal transmission system is a signal with frequency hopping and amplitude hopping, due to inconsistent amplitude-frequency characteristics of the signal transmission system itself or defects of the pre-distortion algorithm, correction of the pre-distortion system will be affected, resulting in that an intermodulation distortion is not stable, intermodulation power will jump. In the above preferred embodiments of the present disclosure, a stable wideband signal is added to the system input signal, so the system input signal is a relatively stable signal for the pre-distortion unit 101. Even though the amplitude and frequency of the input signal vary greatly, due to the existence of the wideband signal, the bandwidth of the input signal of the pre-distortion unit 101 is unchanged and an amplitude variation is basically stable within a certain range, so the correction effect is relatively good.

As shown in FIG. 7, although the frequency or the bandwidth of the input signal is arbitrarily adjusted between an operating frequency f1 and an operating frequency f2, the bandwidth of the system input signal is always between the frequency f3 and the frequency f4 for the pre-distortion unit 101. At the same time, even though the amplitude of the input signal is greatly reduced, due to the presence of the signal S3 and the signal S4, the power of the system input signal remains above a certain range for the pre-distortion unit 101, so the pre-distortion correction can be continued for the system.

At step 505, the output signal of the system is filtered, resulting in reducing the power of the wideband signal entering the system to not affect a performance of the system.

When one or more wideband signals are introduced into the system, the wideband signal itself, an intermodulation signal between wideband signal parameters and an intermodulation signal between parameters of the wideband signal and parameters of system signal will affect a spurious level of the system. Therefore, the spurious signal can be removed or reduced by filtering.

Alternatively, the output signal of the system can be filtered by adding a filtering unit to the output terminal of the system.

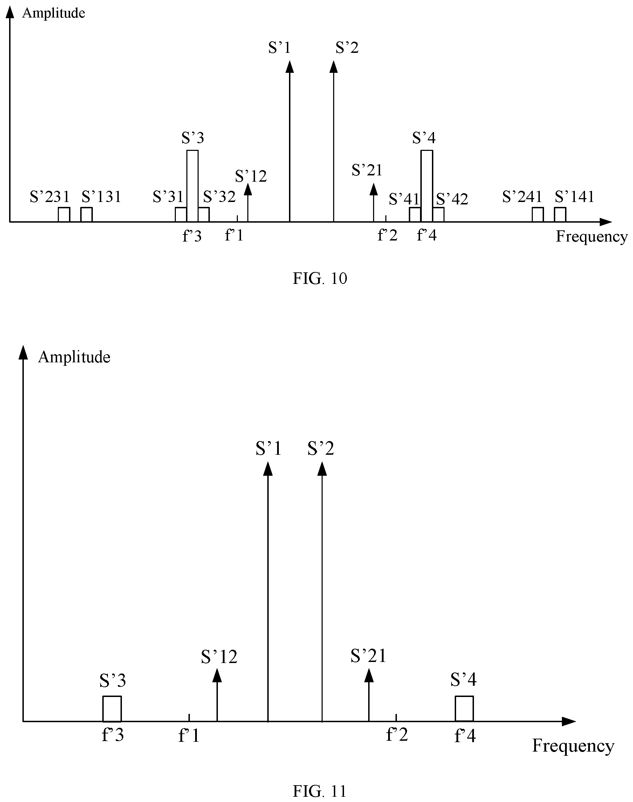

The signals corrected by the system are shown in FIG. 10. In addition to the system input signal S'1, the system input signal S'2 and the intermodulation signals S'12 and S'21 generated by S'1 and S'2, the signals corrected by the system also include the wideband signal S'3, the wideband signal S'4 introduced from the system and their own intermodulation signals S'31, S'32, S'41, S'42, and the intermodulation signals S'231, S'131, S'241, S'141 between the wideband signal and the input signal. The intermodulation signals S'12, S'21, S'31, S'32, S'41, S'42, S'231, S'131, S'241, S'141 can be improved after system pre-distortion correction, but the wideband signal S'3 and the wideband signal S'4 cannot be corrected. The existence of the wideband signal S'3 and the wideband signal S'4 will affect the out-of-band spurious level of the system, and may bring interference to the system itself or other systems. Therefore, in the preferred embodiment of the present disclosure, a filtering unit is added to a signal output terminal of the system to further filter out the corresponding wideband signal and multiple intermodulation signals. For the system with a filtering unit originally, the corresponding out-of-band suppression index can be strictly controlled to achieve the same purpose. Generally, after filtering by the filtering unit, the spurious signal out of band of the system can be significantly improved, as shown in FIG. 11.

Above all, in the above pre-distortion processing device, the signal transmission system and the pre-distortion processing method of the embodiments of the present disclosure, a group of stable wideband signals are added to the input signal of the pre-distortion system to enhance a stability of the pre-distortion, resulting in that some systems that are not suitable for the pre-distortion technology also can improve signal linear index by the pre-distortion techniques, and improving an efficiency index and cost pressure of the system by improving the linear index at the same time. At the same time, the frequency of the wideband signal can be reasonably allocated by a wideband signal generation unit, and the wideband signal and the spurious signal such as the relative intermodulation signal can be re-filtered by the filtering unit at the output terminal of the system, resulting in that the system does not generate an additional spurious signal to interfere with the system on the basis of improving the signal linear index.

## Claims

1. A pre-distortion processing device, comprising a pre-distortion unit (101), **characterized in that** the pre-distortion processing device further comprises a transmission unit (102), a coupling unit (103), a generation unit (105) and a combiner unit (106); the pre-distortion unit (101), the transmission unit (102), and the coupling unit (103) are sequentially connected, and a feedback path (104) of the coupling unit (103) is connected to the pre-distortion unit (101),
the generation unit (105) is configured to generate a wideband signal having a bandwidth greater than that of a system input signal, and the wideband signal is a non-hopping signal;
the combiner unit (106) comprises a first input terminal, a second input terminal and an output terminal, wherein the first input terminal of the combiner unit (106) is connected to an output terminal of the generation unit (105), the second input terminal of the combiner unit (106) is configured to receive the system input signal, the output terminal of the combiner unit (106) is connected to an input terminal of the pre-distortion unit (101), the combiner unit (106) is configured to combine the wideband signal and the system input signal into a combined signal and output the combined signal to the pre-distortion unit (101);
the transmission unit (102) is configured to power-amplify a baseband signal output by the pre-distortion unit (101); and
the coupling unit (103) is configured to couple a part of an output signal of the transmission unit (102) as a feedback signal and provide the feedback signal to the pre-distortion unit (101) for pre-distortion processing of the baseband signal.

2. The pre-distortion processing device of claim 1, wherein the device further comprises a filtering unit (107), an input terminal of the filtering unit (107) is connected to an output terminal of the coupling unit (103), and an output terminal of the filtering unit (107) is connected to an antenna (108).

3. The pre-distortion processing device of claim 2, wherein a frequency of the wideband signal processed by the transmission unit (102) is outside a passband frequency range of the filtering unit (107).

4. The pre-distortion processing device of claim 3, wherein an interval between the frequency of the wideband signal processed by the transmission unit (102) and the passband frequency of the filtering unit (107) is within a preset range.

5. The pre-distortion processing device of claim 1, wherein a number of the wideband signal generated by the generation unit (105) is one or more; when a plurality of wideband signals are generated by the generation unit (105), a frequency of at least one of the plurality of wideband signals is less than that of the system input signal, and a frequency of at least one of the plurality of wideband signals is greater than that of the system input signal.

6. The pre-distortion processing device of claim 1, wherein the wideband signal comprises at least one of a WCDMA signal and a LTE signal.

7. The pre-distortion processing device of claim 2, wherein the filtering unit (107) is configured to filter the wideband signal processed by the transmission unit (102) and a spurious signal in an output signal of the transmission unit (102), and the spurious signal comprises an intermodulation signal generated by the wideband signal.

8. A signal transmission system, comprising the pre-distortion processing device of any one of claims 1 to 7.

9. A pre-distortion processing method, **characterized by**:
receiving a combined signal by a pre-distortion unit (101), wherein the combined signal comprises a wideband signal and a system input signal, a bandwidth of the wideband signal is greater than that of the system input signal, and the wideband signal is a non-hopping signal;
the pre-distortion processing method further comprises
receiving a feedback signal by the pre-distortion unit (101), wherein the feedback signal is a signal coupled from an output signal, and the output signal is obtained by power amplification of the combined signal after pre-distortion processing; and
performing pre-distortion processing on the combined signal by the pre-distortion unit (101) according to the feedback signal and obtaining the combined signal after pre-distortion processing.

10. The pre-distortion processing method of claim 9, wherein
a processed wideband signal and a spurious signal are filtered out of the output signal, and the spurious signal comprises intermodulation signals generated by the wideband signal.

## Patentansprüche

1. Eine Vorverzerrungsverarbeitungsvorrichtung, die eine Vorverzerrungseinheit (101) umfasst, **dadurch gekennzeichnet, dass** die Vorverzerrungsverarbeitungsvorrichtung ferner eine Übertragungseinheit (102), eine Kopplungseinheit (103), eine Erzeugungseinheit (105) und eine Kombiniereinheit (106) umfasst; die Vorverzerrungseinheit (101), die Übertragungseinheit (102) und die Kopplungseinheit (103) sequenziell verbunden sind und ein Rückkopplungspfad (104) der Kopplungseinheit (103) mit der Vorverzerrungseinheit (101) verbunden ist,
die Erzeugungseinheit (105) dazu konfiguriert ist, ein Breitbandsignal zu erzeugen, das eine größere Bandbreite als die eines Systemeingangssignals aufweist, und das Breitbandsignal ein nicht springendes Signal ist;
die Kombiniereinheit (106) einen ersten Eingangsanschluss, einen zweiten Eingangsanschluss und einen Ausgangsanschluss umfasst, wobei der erste Eingangsanschluss der Kombiniereinheit (106) mit einem Ausgangsanschluss der Erzeugungseinheit (105) verbunden ist, der zweite Eingangsanschluss der Kombiniereinheit (106) dazu konfiguriert ist, das Systemeingangssignal zu empfangen, der Ausgangsanschluss der Kombiniereinheit (106) mit einem Eingangsanschluss der Vorverzerrungseinheit (101) verbunden ist und die Kombiniereinheit (106) dazu konfiguriert ist, das Breitbandsignal und das Systemeingangssignal zu einem kombinierten Signal zu kombinieren und das kombinierte Signal an die Vorverzerrungseinheit (101) auszugeben;
die Übertragungseinheit (102) dazu konfiguriert ist, die Leistung eines von der Vorverzerrungseinheit (101) ausgegebenen Basisbandsignals zu verstärken; und
die Kopplungseinheit (103) dazu konfiguriert ist, einen Teil eines Ausgangssignals der Übertragungseinheit (102) als Rückkopplungssignal zu koppeln und das Rückkopplungssignal der Vorverzerrungseinheit (101) zur Vorverzerrungsverarbeitung des Basisbandsignals bereitzustellen.

2. Die Vorverzerrungsverarbeitungsvorrichtung nach Anspruch 1, wobei die Vorrichtung außerdem eine Filtereinheit (107) umfasst, ein Eingangsanschluss der Filtereinheit (107) mit einem Ausgangsanschluss der Kopplungseinheit (103) verbunden ist und ein Ausgangsanschluss der Filtereinheit (107) mit einer Antenne (108) verbunden ist.

3. Die Vorverzerrungsverarbeitungsvorrichtung nach Anspruch 2, wobei eine Frequenz des von der Übertragungseinheit (102) verarbeiteten Breitbandsignals außerhalb eines Durchlassfrequenzbereichs der Filtereinheit (107) liegt.

4. Die Vorverzerrungsverarbeitungsvorrichtung nach Anspruch 3, wobei ein Intervall zwischen der Frequenz des von der Übertragungseinheit (102) verarbeiteten Breitbandsignals und der Durchlassfrequenz der Filtereinheit (107) innerhalb eines voreingestellten Bereichs liegt.

5. Die Vorverzerrungsverarbeitungsvorrichtung nach Anspruch 1, wobei eine Anzahl der von der Erzeugungseinheit (105) erzeugten Breitbandsignale eins oder mehr beträgt; wenn eine Vielzahl von Breitbandsignalen von der Erzeugungseinheit (105) erzeugt wird, ist eine Frequenz von mindestens einem der Vielzahl von Breitbandsignalen kleiner als die des Systemeingangssignals und eine Frequenz von mindestens einem der Vielzahl von Breitbandsignalen ist größer als die des Systemeingangssignals.

6. Das Vorverzerrungsverarbeitungsgerät nach Anspruch 1, wobei das Breitbandsignal mindestens ein WCDMA-Signal und ein LTE-Signal umfasst.

7. Die Vorverzerrungsverarbeitungsvorrichtung nach Anspruch 2, wobei die Filtereinheit (107) dazu konfiguriert ist, das von der Übertragungseinheit (102) verarbeitete Breitbandsignal und ein Störsignal in einem Ausgangssignal der Übertragungseinheit (102) zu filtern, und das Störsignal ein von dem Breitbandsignal erzeugtes Intermodulationssignal umfasst.

8. Ein Signalübertragungssystem, das die Vorverzerrungsverarbeitungsvorrichtung nach einem der Ansprüche 1 bis 7 umfasst.

9. Ein Vorverzerrungsverarbeitungsverfahren, **gekennzeichnet durch**:
Empfangen eines kombinierten Signals durch eine Vorverzerrungseinheit (101), wobei das kombinierte Signal ein Breitbandsignal und ein Systemeingangssignal umfasst, eine Bandbreite des Breitbandsignals größer ist als die des Systemeingangssignals und das Breitbandsignal ein nicht springendes Signal ist;
das Vorverzerrungsverfahren umfasst weiterhin
Empfangen eines Rückkopplungssignals durch die Vorverzerrungseinheit (101), wobei das Rückkopplungssignal ein von einem Ausgangssignal gekoppeltes Signal ist und das Ausgangssignal durch Leistungsverstärkung des kombinierten Signals nach der Vorverzerrungsverarbeitung erhalten wird; und
Durchführen einer Vorverzerrungsverarbeitung an dem kombinierten Signal durch die Vorverzerrungseinheit (101) entsprechend dem Rückkopplungssignal und Erhalten des kombinierten Signals nach der Vorverzerrungsverarbeitung.

10. Das Vorverzerrungsverfahren nach Anspruch 9, wobei ein aus dem Ausgangssignal verarbeitetes Breitbandsignal und ein Störsignal herausgefiltert werden und das Störsignal Intermodulationssignale umfasst, die durch das Breitbandsignal erzeugt werden.

## Revendications

1. Un dispositif de traitement de prédistortion, comprenant une unité de prédistortion (101), **caractérisé en ce que** le dispositif de traitement de prédistortion comprend en outre une unité de transmission (102), une unité de couplage (103), une unité de génération (105) et une unité de combinaison (106) ; l'unité de prédistortion (101), l'unité de transmission (102), et l'unité de couplage (103) sont raccordées en séquence, et un trajet de rétroaction (104) de l'unité de couplage (103) est raccordé à l'unité de prédistortion (101),
l'unité de génération (105) est configurée pour générer un signal à large bande doté d'une bande passante supérieure à celle d'un signal d'entrée système, et le signal à large bande est un signal sans saut ;
l'unité de combinaison (106) comprend un premier terminal d'entrée, un deuxième terminal d'entrée et un terminal de sortie, dans lesquels le premier terminal d'entrée de l'unité de combinaison (106) est raccordé à un terminal de sortie de l'unité de génération (105), le deuxième terminal d'entrée de l'unité de combinaison (106) est configuré pour recevoir le signal d'entrée système, le terminal de sortie de l'unité de combinaison (106) est raccordé à un terminal d'entrée de l'unité de prédistortion (101), l'unité de combinaison (106) est configurée pour combiner le signal à large bande et le signal d'entrée système et le signal combiné de sortie à l'unité de prédistortion (101) ;
l'unité de transmission (102) est configurée pour amplifier la puissance de sortie d'un signal en bande de base par l'unité de prédistortion (101) ; et
l'unité de couplage (103) est configurée pour coupler une partie du signal de sortie de l'unité de transmission (102) comme signal de rétroaction et fournir un signal de rétroaction à l'unité de prédistortion (101) pour traitement de prédistortion du signal en bande de base.

2. Un dispositif de traitement de prédistortion selon la revendication 1, dans lequel le dispositif comprend en outre une unité de filtrage (107), un terminal d'entrée de l'unité de filtrage (107) est raccordé à un terminal de sortie de l'unité de couplage (103), et un terminal de sortie de l'unité de filtrage (107) est raccordé à une antenne (108).

3. Un dispositif de traitement de prédistortion selon la revendication 2, dans lequel la fréquence du signal à large bande traité par l'unité de transmission (102) est à l'extérieur de l'amplitude de fréquence de la bande passante de l'unité de filtrage (107).

4. Un dispositif de traitement de prédistortion selon la revendication 3, dans lequel l'intervalle entre la fréquence du signal à large bande traité par l'unité de transmission (102) et la fréquence de bande passante de l'unité de filtrage (107) est compris dans une amplitude prédéfinie.

5. Un dispositif de traitement de prédistortion selon la revendication 1, dans lequel le nombre de signaux à large bande générés par l'unité de génération (105) est de un ou plus ; lorsqu'une pluralité de signaux à large bande est générée par l'unité de génération (105), la fréquence d'au moins un signal de la pluralité de signaux à large bande est inférieure à celle du signal d'entrée système, et la fréquence d'au moins un signal de la pluralité de signaux à large bande est supérieure à celle du signal d'entrée système.

6. Un dispositif de traitement de prédistortion selon la revendication 1, dans lequel le signal à large bande comprend au moins un signal WCDMA et un signal LTE signal.

7. Un dispositif de traitement de prédistortion selon la revendication 2, dans lequel l'unité de filtrage (107) est configurée pour filtrer le signal à large bande traité par l'unité de transmission (102) et un signal parasite dans un signal de sortie de l'unité de transmission (102), et le signal parasite comprend un signal d'intermodulation généré par le signal à large bande.

8. Un système de transmission de signaux, comprenant le dispositif de traitement de prédistortion selon l'une quelconque des revendications 1 à 7.

9. Un procédé de traitement de prédistortion, **caractérisé par** :
la réception d'un signal combiné par une unité de prédistortion (101), dans lequel le signal combiné comprend un signal à large bande et un signal d'entrée système, la bande passante est supérieure à celle d'un signal d'entrée système, et le signal à large bande est un signal sans saut ;
le procédé de traitement de prédistortion comprend en outre :
la réception d'un signal de rétroaction par l'unité de prédistortion (101), dans laquelle le signal de rétroaction est un signal couplé depuis un signal de sortie, et le signal de sortie est obtenu par amplification de puissance du signal combiné après traitement de prédistortion ; et
le traitement de prédistortion du signal combiné par l'unité de prédistortion (101) en fonction du signal de rétroaction et l'obtention du signal combiné après traitement de prédistortion.

10. Un procédé de traitement de prédistortion selon la revendication 9, dans lequel un signal à large bande traité et un signal parasite sont filtrés du signal de sortie, et le signal parasite comprend des signaux d'intermodulation générés par le signal à large bande.
